# EUROPÄISCHE PATENTSCHRIFT

(11) **EP 0 367 214 B1**
(45) Veröffentlichungstag und Bekanntmachung des Hinweises auf die Patenterteilung: **01.10.1997**
(21) Anmeldenummer: 89120170.9
(22) Anmeldetag: 31.10.1989
(51) Int. Cl.: H03J 7/28, H04H 1/00

(54) **Satelliten-Rundfunkempfänger**
Satellite broadcast receiver
Récepteur de radiodiffusion par satellite

(30) Priorität: 02.11.1988 DE 3837130
(43) Veröffentlichungstag der Anmeldung: 09.05.1990
(73) Patentinhaber: Deutsche Thomson-Brandt GmbH, 78010 Villingen-Schwenningen (DE)
(72) Erfinder: Klank, Otto, Dipl.-Ing., D-3160 Lehrte-Arpke (DE); Eilts-Grimm, Klaus, Dipl.-Ing., D-2120 Lüneburg (DE); Laabs, Jürgen, Dipl.-Ing., D-3017 Pattensen (DE)
(74) Vertreter: Hartnack, Wolfgang, Dipl.-Ing.

(56) Entgegenhaltungen:
- EP-A- 0 028 100
- US-A- 4 405 947
- ICDSC-7 PROCEEDINGS, München, DE, 12.-16. Mai 1986, Seiten 57-62; O. KLANK:"Receiver for Digital Sound Broadcasting Service Satellite DSR"

## Beschreibung

Die Erfindung betrifft einen Satelliten-Rundfunkempfänger.

Signale, die Satelliten-Rundfunkempfänger von einer Satellitenempfangsanlage erhalten, können einer Frequenzdrift unterliegen. Ursache der Frequenzdrift ist ein instabiler Oszillator der Satellitenempfangsanlage oder weiterer zwischengeschalteter Umsetzer. Dabei wirken sich wegen der hohen Übertragungsfrequenz schon geringe relative Frequenzabweichungen auf die Zwischenfrequenz im Satelliten-Rundfunkempfänger als starke absolute Abweichung aus. Diese Erscheinung kann dazu führen, daß die automatische Frequenzregelung des Trägeroszillators für die Demodulationsschaltung die Frequenzdrift nicht mehr ausgleichen kann.

Der Erfindung liegt die Aufgabe zugrunde, einen Satelliten-Rundfunkempfänger dahingehend zu verbessern, daß auch bei Frequenzabweichungen des Empfangssignals, die über den Regelbereich der automatischen Frequenzregelung für den Trägeroszillator hinausgehen, eine schnelle und zuverlässige Abstimmung ermöglicht wird.

Das Dokument EP-A-0 028 100 veröffentlicht ein Empfangsteil, das entwedes einen PLL-oder einen AFC-Regelkreis benützt, wenn die Frequenz des empfangenen Signals weiter von oder näher bei einer bestimmten Frequenz liegt.

Diese Aufgabe wird bei einem Satelliten-Rundfunkempfänger nach dem Oberbegriff des Anspruchs 1 durch die im Kennzeichen angegebenen Merkmale gelöst.

Die Erfindung nutzt als Kriterium für die Abstimmung zunächst ein fehlendes Synchronsignal aus. In diesem Fall wird der PLL-Überlagerungsoszillator in großen Frequenzschritten abgestimmt (Suchlauf). Dadurch gelingt sehr schnell eine Annäherung an die für die Kompensation der Frequenzabweichung optimale Überlagerungsfrequenz. Dadurch wird eine Annäherung an den Fangbereich, beispielsweise des 4PSK Demodulators, erreicht. Wird ein Synchronsignal empfangen, werden die Frequenzschritte für die Endabstimmung des PLL-Überlagerungsoszillators verkleinert. Die weitere Abstimmung des PLL-Überlagerungsoszillators erfolgt dann in kleinen Frequenzschritten so lange, bis die Frequenzabweichung des Demodulators -VCOS innerhalb der Grenzen eines Fensters liegt, das im Umgebungsbereich der Mittenfrequenz des Abstimmbereichs liegt und beispielsweise kleiner ist als die Grenzen zweier kleiner Schrittweiten.

Weiterbildungen und vorteilhafte Ausgestaltungen der Erfindung ergeben sich aus den Ansprüchen, der weiteren Beschreibung und der Zeichnung, die ein Ausführungsbeispiel der Erfindung veranschaulicht.

In der Zeichnung zeigen:
- Fig. 1: ein Blockschaltbild eines Satelliten-Tonrundfunk empfängers mit einer Satellitenempfangsanlage und
- Fig. 2: ein Schaltbild einer Komparatorschaltung als Bestandteil einer AFC-Schaltung aus Fig. 1
- Fig. 3: ein Schaltbild für die Gewinnung eines Fehlersignals aus dem Concealment-Signal.

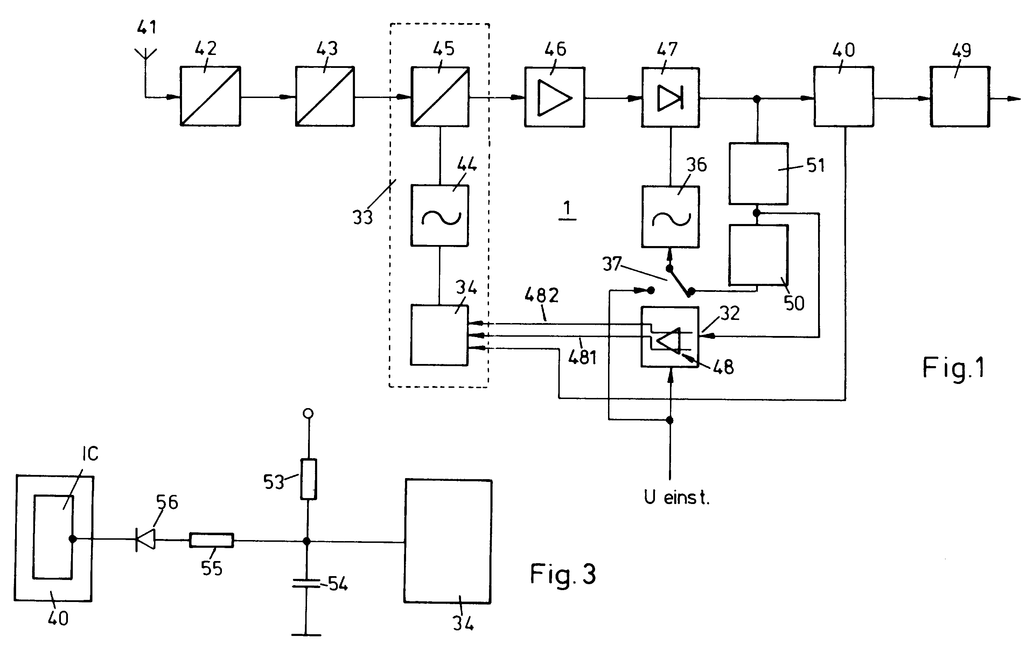

Fig. 1 zeigt ein Blockschaltbild eines Satelliten-Rundfunkempfängers, der an eine Satellitenempfangsanlage angeschlossen ist. Die Satellitenempfangsanlage besteht aus einer Satellitenantenne 41 sowie zwei Frequenzumsetzern 42 und 43. Der Satelliten-Rundfunkempfänger umfaßt ein Empfangsteil 33 mit einem Mischer 45, einem PLL-Überlagerungsoszillator 44 und einer Steuerschaltung 34, einen ZF-Verstärker 46, eine Demodulatorschaltung 47, einen Trägeroszillator 36, eine AFC-Schaltung 1, eine Synchronsignalauswerteschaltung 40 sowie eine Decodierschaltung 49. Am Ausgang der Decodierschaltung 49 sind Tonsignale abgreifbar.

Wird die Empfangsfrequenz sehr genau eingehalten, so kann der PLL-Überlagerungsoszillator 44 auf eine vorgegebene, vereinbarte Frequenz eingestellt werden und am Ausgang des Mischers 45 ergibt sich dann eine Zwischenfrequenz mit dem Nennwert der ZF. In der dem ZF-Verstärker 46 nachgeschalteten Demodulatorschaltung 47 kann das vorzugsweise in 4PSK-Modulation vorliegende Signal demoduliert werden. Zur Trägerregenerierung bei der Demodulation dienen der Trägeroszillator 36, der so gesteuert wird, daß er phasensynchron zum modulierten Signal schwingt. Dabei erhält der Oszillator 36 das Eingangssignal vom Ausgang der Demodulatorschaltung 47 über das Schleiffilter 51.

Weicht die Empfangsfrequenz von ihrem Nennwert ab, so kann der Demodulator 47 den Trägeroszillator 36 nicht mehr nachziehen. Dieser an sich für die Signalrückgewinnung nachteilige Effekt wird ausgenutzt, um über die Steuerschaltung 34 dem Überlagerungsoszillator 44 so nachzuregeln, daß die Zwischenfrequenz auf ihren Nennwert geregelt wird. In diesem Fall erhält also die Steuerschaltung 34, insbesondere ein Mikroprozessor, den Befehl, den PLL-Überlagerungsoszillator 44 schrittweise nachzustimmen. Die Nachstimmrichtung wird dabei von dem jeweiligen Ausgang der Schaltungen 40, 48 vorgegeben. Gleichzeitig erhält die Steuerschaltung 34 auch von der Synchronsignalauswerteschaltung 40 ein Signal, dessen Zustand von Erkennung oder Nichterkennung eines Synchronsignals abhängt. Ist kein Synchronsignal vorhanden, hat der Demodulator 47 also nicht gefangen, erfolgt die Nachstimmung des PLL-Überlagerungsoszillators 44 in großen Schritten von vorzugsweise 250 kHz. Ist dagegen ein Synchronsignal vorhanden, wird der PLL-Überlagerungsoszillator 44 in kleinen Schritten von vorzugsweise 62,5 kHz abgestimmt. Die zeitliche Schrittfolge ist so bemessen, daß sie der Systemeinschwingzeit entspricht. Der Abstimmvorgang wird also nach Art eines Suchlaufs solange fortgesetzt, bis der Demodulator gefangen hat. Der Abstimmvorgang im Fangbereich wird in kleinen Schritten fortgesetzt, bis ein Fenster der Weite zweier kleiner Schritte um die Mittenfrequenz des Demodulators erreicht ist.

Zur Ansteuerung der Steuerschaltung 34, insbesondere des Mikroprozessors, enthält die AFC-Schaltung 1 eine Komparatorschaltung 48, die das AFC-Signal mit einem oberen und einem unterem Schwellwert vergleicht.

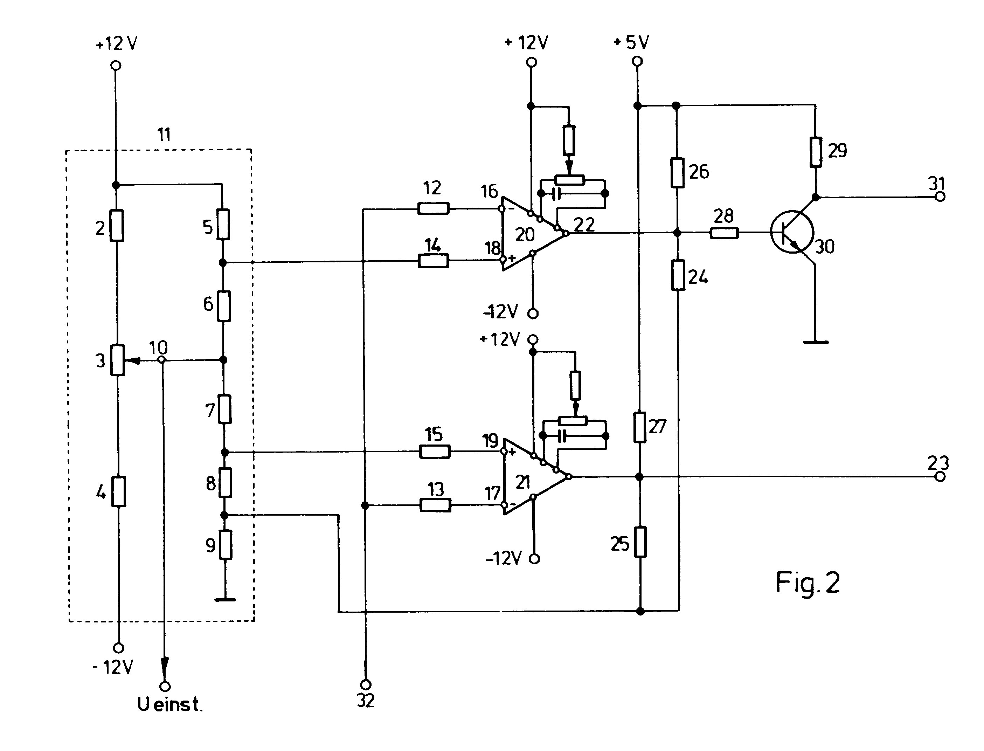

Fig. 2 zeigt die Ausgestaltung einer Komparatorschaltung 48 , wobei ein erster Komparator 20 für den oberen und ein zweiter Komparator 21 für den unteren Schwellwert vorgesehen ist. Den einen Eingängen 16, 17 der Komparatoren 20, 21 wird das AFC-Signal über Widerstände 12 und 13 und den anderen Eingängen 18, 19 werden Vergleichsspannungen über Widerstände 14 und 15 sowie eine Spannungsteilerschaltung 5...9 zugeführt. Ausgänge 31, 23 der Komparatorschaltung 48 sind mit der Steuerschaltung 34 verbunden, wobei der Ausgang 31 die eine und der andere Ausgang 23 die andere Abstimmrichtung vorgibt.

Zwei Endanschlüsse der Spannungsteilerschaltung 5...9 liegen an festen Bezugsspannungen +U, Masse und eine Anzapfung an einer einstellbaren Bezugsspannung Uₑᵢₙₛₜ. Eine weitere Anzapfung liegt an einer Mitkopplungsspannung Uₘᵢₜ, die an den Ausgängen 22, 23 der Komparatoren 20, 21 abgegriffen wird. Die einstellbare Bezugsspannung Uₑᵢₙₛₜ wird auf einen Wert eingestellt, der den Trägeroszillator 36 auf eine Nennfrequenz fₙₑₙₙ abstimmt.

Die Spannungsteilerschaltung umfaßt eine Reihenschaltung aus Widerständen 5, 6, 7, 8 und 9, wobei der Widerstand 5 mit seinem freien Ende auf positivem Potential +U, während der Widerstand 9 mit seinem freien Ende auf Nullpotential (Masse) liegt. Der Eingang 18 des ersten Komparators 20 ist über den Widerstand 14 mit der Anzapfung zwischen den Widerständen 5 und 6 und der Eingang 19 des zweiten Komparators 21 über den Widerstand 15 mit der Anzapfung zwischen den Widerständen 7 und 8 verbunden. Die Anzapfung zwischen dem Widerstand 6 und 7 liegt an der einstellbaren Bezugsspannung Uₑᵢₙₛₜ, während die Anzapfung zwischen den Widerständen 8 und 9 an der Mittkopplungsspannung Uₘᵢₜ liegt.

Die einstellbare Bezugsspannung Uₑᵢₙₛₜ wird in einer Schaltungsanordnung erzeugt, die eine Reihenschaltung aus einem Widerstand 2, einem veränderbaren Widerstand 3 mit einem Abgriff 10 und einem Widerstand 4 umfaßt, wobei der Widerstand 2 mit seinem freien Ende an einem positiven Potential +U, während der Widerstand 4 mit seinem freien Ende an einem negativen Potential -U liegt. Der Abgriff 10 ist mit der Anzapfung zwischen den Widerständen 6 und 7 verbunden. Eine weitere Verbindung des Abgriffs 10 besteht zu einem für einen Abgleich dienenden Schalter 37, über den der Abgriff 10 mit dem Steuereingang des Trägeroszillators 36 verbindbar ist.

Der Ausgang 22 des ersten Komparators 20 ist über einen Vorwiderstand 28 mit dem Steuereingang eines als NPN-Transistor ausgebildeten Inverters 30 verbunden, dessen Ausgang den ersten Ausgang 31 der Komparatorschaltung 48 bildet. Der Ausgang des zweiten Komparators 21 bildet den zweiten Ausgang 23 der Komparatorschaltung 48.

Zur Mitkopplung des Ausgangssignals auf die Eingänge 18 und 19 sind die Ausgänge 22 und 23 über Widerstände 24 und 25 mit den Anzapfungen zwischen den Widerständen 8 und 9 verbunden. Außerdem liegen die Ausgänge 22 und 23 über Widerstände 26 und 27 ebenso auf dem positiven Potential +5V wie ein mit dem Ausgang 31 des Transistors verbundener Widerstand 29, wodurch sich hinsichtlich des Signalpegels eine TTL-Anpassung ergibt.

Die soweit beschriebene Schaltungsanordnung arbeitet wie folgt:

Zur Einstellung der richtigen Bezugsspannung für die Komparatoren 20 und 21 wird durch Schließen des Schalters 37 der Steuereingang des während des Abgleichs vorübergehend freilaufenden Trägeroszillators 36 mit dem Abgriff 10 des veränderbaren Widerstandes 3 verbunden. Durch Einstellen des veränderbaren Widerstandes 3 wird nun die dem Steuereingang des Trägeroszillators 36 zugeführte Spannung so eingestellt, daß dieser auf die Trägerfrequenz von im Ausführungsbeispiel 70 MHz abgeglichen werden kann.

Bei der soweit beschriebenen Schaltung bewirkt eine Temperaturänderung beispielsweise eine Verschiebung des Fensters relativ zur Mittenfrequenz des Demodulators 47. Zur Kompensation des Temperatureinflusses dient eine Temperaturkompensationsschaltung 50. Da die Abstimmspannung für den Steuereingang des VCO 36 mit dem Einfluß der Temperaturkompensationsschaltung 50 beaufschlagt ist, ist die Abstimmspannung bereits am Ausgang eines Schleifenfilters 51 abzunehmen bzw. dem Signaleingang 32 der Schaltungsanordnung 1 zuzuführen, sowie das Referenzpotential (Uₑᵢₙₛₜ) für Sollabstimmung auf den Ausgang des Schleifenfilters 51 zu beziehen.

Zur Gewinnung des Referenzpotentials Uₑᵢₙₛₜ wird das bei der Grundeinstellung des VCO 36 an der Anzapfung 10 in Fig. 2 eingestellte positive Potential +6,7V zunächst um den Spannungsabfall an der Temperaturkompensationsschaltung 50 mit dem veränderbaren Widerstand 3 verringert und anschließend mittels eines z.B. über 41 eingespeisten verstimmbaren Meßempfangssignals in der Weise eingestellt, daß der Schaltpunkt des Komparators 20 mit der unteren und der Schaltpunkt des Komparatos 21 mit der oberen zulässigen Frequenzabweichung von der Trägersignalfrequenz 70MHz zusammenfällt. Dabei ergibt sich zwangsläufig, daß das auf diese Weise an der Anzapfung 10 gewonnene Referenzpotential eine frequenzsymmetrische Lage zu den Schaltpunkten einnimmt. Beide Schaltpunkte geben somit ein Fenster für Abstimmung und Abstimmrichtung vor.

Der Schaltpunkt des ersten Komparators 20 liegt um den Spannungsabfall an dem Widerstand 6 zuzüglich einer Hysteresespannung oberhalb der Bezugsspannung Uₑᵢₙₛₜ und der Schaltpunkt des zweiten Komparators 21 um den Spannungsabfall an dem Widerstand 7 zuzüglich einer geringfügigen Hysteresespannung unterhalb der Bezugsspannung Uₑᵢₙₛₜ. Damit ist ein Fenster für die Grenzen der Frequenzabweichungen festgelegt. Außerhalb des Fensters wird eine schrittweise Nachstimmung des PLL-Überlagerungsoszillators 44 in kleinen Schrittweiten vorgenommen und die Abstimmrichtungen sind differenziert vorgegeben. Innerhalb des Fensters ruht das System, der Regelkreis wirkt unterbrochen.

Zur automatischen Frequenzregelung wird dem Signaleingang 32 der Komparatorschaltung 48 die Abstimmspannung des Trägeroszillators 36 zugeführt und mit den Potential des Schaltpunktes des ersten Komparators 20 und des zweiten Komparators 21 verglichen. Befindet sich die Abstimmspannung innerhalb des Fensters, liegt der Ausgang 23 an der positiven Aussteuergrenze, während der Ausgang 22 des ersten Komparators 20 zur negativen Aussteuerungsgrenze durchgeschaltet ist. Dadurch ist der Transistors 30 gesperrt ist und Ausgang 31 liegt ebenfalls an der positiven Aussteuerungsgrenze. Die Ausgänge 23 und 31 führen somit beide Signale logisch H. Der PLL-Überlagerungsoszillator 44 ist richtig abgestimmt.

Überschreitet die Abstimmspannung des Trägeroszillators 36 infolge einer auftretenden Verstimmung das Potential des Schaltpunktes des ersten Komparators 20 um die Hysteresespannung, so wird der Ausgang 31 zur negativen Aussteuergrenze durchgeschaltet, während der Ausgang 23 die Lage an der positiven Aussteuerungsgrenze beibehält. Die Ausgänge 31 und 23 führen somit die Signale logisch L und logisch H. Die Frequenz des PLL-Überlagerungsoszillators 44 wird nachgeregelt.

Unterschreitet die Abstimmspannung des Trägeroszillators 36 infolge einer entgegengerichtet laufenden Verstimmung das Potential des Schaltpunktes des zweiten Komparators 21 um die Hysteresespannung, so wird der Ausgang 23 zur negativen Aussteuergrenze durchgeschaltet, während in diesem Fall der Ausgang 31 die Lage an der positiven Aussteuergrenze beibehält. Die Ausgänge 31 und 23 führen in diesem Fall die Signale logisch H und logisch L. Die Frequenzregelung des PLL-Überlagerungsoszillators 44 wirkt in diesem Fall in entgegengesetzter Richtung.

Bei fehlendem Synchronsignal sind die an den Ausgängen 23 und 31 angeschlossenen Eingänge von der Synchronsignalauswerteschaltung 40 auf inaktiv geschaltet, so daß der Regelkreis unterbrochen ist. Die Steuerschaltung 34 startet einen Sendersuchlauf. Wird ein Signal erkannt bzw. wird ein Synchronsignal erzeugt, übernimmt der Regelkreis die weitere Nachstimmung, wobei die Steuerschaltung 34 die von der Komparatorschaltung 48 erhaltenen Signale zur Gewinnung der Abstimmrichtung auswertet.

Die beschriebene Schaltung hat den Vorteil, daß die Fensterbreite unabhängig von der Einstellung des veränderbaren Widerstandes 3 ist. Durch die Dimensionierung der Widerstände innerhalb der Spannungsteilerschaltung und die Anordnung der Widerstände 6 und 7 zur Gewinnung der Komparatorschaltpunkte wird erreicht, daß eine Einstelländerung aufgrund eines eventuell notwendigen Bauteilersatzes gleiche Potentialverschiebungen an den Eingängen 18 und 19 der Komparatoren 20 und 21 zur Folge hat.

Die 4PSK-Demodulatorschaltung 47 beinhaltet einen Phasenregelkreis 47, 51, 50, 36 (PLL) in welchem bei Signalempfang zur Rückgewinnung des im Signalspektrum nicht vorhandenen Trägersignals dem Steuereingang eines spannungsgesteuerten Oszillators (VCO) 36 eine aus den Ausgangssignalen der 4PSK-Demodulatorschaltung 47 gewonnene Abstimmspannung über ein Schleifenfilter 51 und eine anschließende VCO-Temperaturkompensationsschaltung 50 zugeführt wird. Für eine solche Schaltung ist eine sogenannte Costas Loop vorteilhaft.

Von dem Steuereingang des VCO 36 besteht außerdem eine Verbindung zu einem Schalter 37, über den der Steuereingang mit der Anzapfung 10 des veränderbaren Widerstandes 3 verbunden werden kann bei gleichzeitiger Unterbrechung des Phasenregelkreises. Diese Verbindung ist vorgesehen zur Grundeinstellung des freilaufenden VCO 36 auf eine Frequenz von 70 MHz bei einem positiven Potential +6,7V an der Anzapfung 10 vor der Durchführung des Abgleichs der 4PSK-Demodulatorschaltung.

Die Ausgangsspannung des Schleifenfilters 51 ist ein direktes Maß für die Frequenz bzw. Frequenzablage des Trägersignals in Zwischenfrequenzlage.

Unter Umständen kann die Auswerteschaltung 40 auch bei Nichtvorliegen eines Synchronsignals die Existenz eines solchen Synchronsignals simulieren und die Abstimmung ungünstig beeinflussen.

Fig. 3 zeigt eine Schaltung zur Gewinnung eines Fehlersignals, d.h. eines Fehlersignals zur Steuerung der Steuerschaltung 34, mit der dieser Effekt überwunden werden kann. Zu diesem Zweck ist an die Synchronsignalauswerteschaltung 40 eine Schaltung zur Integration von Concealment-Signalen angeschlossen. Solche Concealment-Signale werden in Auswerteschaltungen für die Bearbeitung von Digitalsignalen üblicherweise erzeugt und ausgewertet, beispielsweise durch ein IC SAA 7500. In Fig. 3 werden diese Concealment Signale integriert. Dies wird erreicht durch ein RC-Glied 53, 54, durch das der Kondensator 54 von der Betriebsspannung UB über den Widerstand 53 auf eine Spannung Logisch High aufgeladen wird. Diese Spannung liegt am Eingang der Steuerschaltung 34 in Fig. 1. Die volle Spannung Logisch High gibt an, daß der Suchlauf eingeleitet wird. Dieser Ladezustand des Kondensators 54 bleibt erhalten, solange Fehlersignale in großer Anzahl am Eingang der Auswerteschaltung 40 auftreten. Sobald die Anzahl der Fehlersignale geringer wird, findet über den Widerstand 55, die Diode 56 und die Schaltung 40 eine Entladung des Kondensators 54 statt; die Spannung am Eingang der Steuerschaltung 34 sinkt ab auf Logisch Low und bewirkt eine Umschaltung auf Abstimmung mit kleiner Schrittweite, bis der Fensterbereich um die Mittenfrequenz des Demodulators 47 erreicht wird. Für die Aufladung des Kondensators 54 mit dem Widerstand 53 ist eine größere Zeitkonstante günstig. Für die Entladung über 57, 40, d.h. für die Umschaltung auf Feinstimmung, ist dagegen eine kleine Zeitkonstante erforderlich.

Für die Steuerschaltung 34 ist ein Mikroprozessor, beispielsweise des Typs µPD7811 vorteilhaft. Dieser kann nicht nur die Aufgaben der Steuerschaltung 34 übernehmen, sondern neben den Auswertungen der Informationen des Komparators 48 und der Synchronsignalschaltung 40 für den Such- und den Feinabstimmvorgang auch das Timing der Umschaltung der Steuerschaltung 34 gemäß Fig. 3 für die Abfrage der Steuerleitungen 481 und 482 und für das schrittweise Verändern der Frequenz des Oszillators 44. Im Such- bzw. Feinabstimmmodus fügt der Prozessor zur Gewährleistung eines einwandfreien Einschwingens des Systems unterschiedliche Wartezeiten ein, die die Integration gemäß Fig. 3 ersetzen oder unterstützen können. Unter ungünstigen Empfangsbedingungen können kurzzeitige Ausfälle der Synchronisation vorkommen. Zu diesem Zeitpunkt darf der Prozessor nicht sofort in den Suchlaufmodus umschalten, weil sonst lange Mutezeiten stören würden. Der Prozessor wartet in einer vorgegebenen Zeitspanne auf eine neue Aufsynchronisierung des Systems, ohne die Abstimmung des Oszillators zu verändern.

Die in Fig. 1 dargestellte Schaltung kann so abgewandelt werden, daß die Frequenz des Oszillators 36 in einem hochgenauen Diskriminator ausgewertet wird und die Steuerspannung der Komparatorschaltung 48 zugeführt wird. Dadurch werden die Temperatureinflüsse verringert.

## Patentansprüche

1. Satelliten-Rundfunkempfänger, welcher mindestens einen Frequenzumsetzer (42, 43) passierende Signale empfängt, mit einem Empfangsteil (33), welches einen Überlagerungsoszillator (44), eine Demodulatorschaltung (47) mit einem Trägeroszillator (36) und eine Synchronsignalauswerteschaltung (40) für die Signalrückgewinnung enthält, dadurch **gekennzeichnet,** daß der Überlagerungsoszillator (44) als in einer großen oder einer kleinen Schrittweite abstimmbarer PLL-Überlagerungsoszillator ausgebildet ist und daß von der Synchronsignalauswerteschaltung (40) und von der Demodulatorschaltung (47) Eingangssignale einer Steuerschaltung (34) abgeleitet werden, mittels der der PLL-Überlagerungsoszillator (44) außerhalb des Fangbereichs der Demodulatorschaltung (47) bei nicht erkannten Synchronsignalen oder daraus gewonnenen Signalen mit großer Schrittweite abgestimmt wird (Suchlauf) und innerhalb des Fangbereichs bei erkannten Synchronsignalen oder daraus gewonnenen Signalen mit kleiner Schrittweite feinabgestimmt wird.

2. Empfänger nach Anspruch 1, wobei die große Schrittweite kleiner ist als der Fangbereich des Demodulators (47), insbesondere 250kHz.

3. Empfänger nach Anspruch 1 oder 2, wobei die kleine Schrittweite so bemessen ist, insbesondere 62,5kHz, daß beim Abstimmvorgang innerhalb des Fangbereiches keine störende Beeinflussung des Ausgangssignals bewirkt wird.

4. Empfänger nach Anspruch 1 oder 2, wobei die AFC-Schaltung (1) eine Komparatorschaltung (48) umfaßt, die das Signal der automatischen Frequenzregelung (AFC-Signal) mit einem oberen und einem unteren Schwellwert vergleicht und die Abstimmrichtung der Steuerschaltung (34) vorgibt.

5. Empfänger nach Anspruch 4, wobei die Komparatorschaltung (48) einen ersten Komparator (20) für den oberen und einen zweiten Komparator (21) für den unteren Schwellwert umfaßt und den einen Eingängen (16, 17) der Komparatoren (20, 21) die AFC-Abstimmspannung (32) und den anderen Eingängen (18, 19) Vergleichsspannungen über eine Spannungsteilerschaltung (5 - 9) zugeführt sind.

6. Empfänger nach Anspruch 5, wobei zwei Endanschlüsse der Spannungsteilerschaltung (5 - 9) an festen Bezugsspannungen (+U, Masse) und eine Anzapfung an einer einstellbaren Bezugsspannung (Uₑᵢₙₛₜ) liegen.

7. Empfänger nach Anspruch 6, wobei eine weitere Anzapfung an einer Mitkopplungsspannung (Uₘᵢₜ) liegt, die an den Ausgängen (22, 23) der Komparatoren (20, 21) abgegriffen wird.

8. Empfänger nach Anspruch 6 oder 7, wobei die einstellbare Bezugsspannung (Uₑᵢₙₛₜ) auf einen Wert eingestellt wird, der den Trägeroszillator (36) auf eine Nennfrequenz (fₙₑₙₙ) abstimmt.

9. Empfänger nach einem der Ansprüche 1 bis 8, wobei das von der Synchronsignalauswerteschaltung (40) abgeleitete Eingangssignal der Steuerschaltung (34) von einer Schaltung zur Auswertung der Fehlerhäufigkeit (concealment) der empfangenen Signale beeinflußt wird und in dieser eine Integration der Fehlersignale erfolgt und die integrierten Fehlersignale als Kriterium für die Umschaltung der Schrittweite dienen.

10. Empfänger nach einem der Ansprüche 1 bis 9, wobei die Abstimmung mit kleiner Schrittweite in beiden Abstimmrichtungen erfolgt.

11. Empfänger nach einem der Ansprüche 1 bis 10, wobei keine Abstimmung erfolgt innerhalb eines Fensters um die Mittenfrequenz des Demodulators (47) mit einer Breite kleiner als zwei kleine Schrittweiten.

12. Empfänger nach einem der Ansprüche 1 bis 11, wobei ein Mischprogramm für die Steuerung der Umschaltung vom Suchlauf auf AFC-Regelung vorgesehen ist.

13. Empfänger nach einem der Ansprüche 1 bis 12 zum Empfang und zur Verarbeitung von digital codierten Audio- oder Videosignalen.

## Claims

1. Satellite broadcast receiver which receives at least one signal traversing a frequency converter (42, 43) and has a receiving section (33) which includes a beat frequency oscillator (44), a demodulator circuit (47) having a carrier oscillator (36) and a synchronising signal processing circuit (40) for recovering the signals, characterised in that, the beat frequency oscillator (44) is constructed as a PLL beat frequency oscillator which is tunable in small or large pitch steps and that input signals for a control circuit (34) are derived from the synchronising signal processing circuit (40) and from the demodulator circuit (47) by means of which the PLL beat frequency oscillator (44) is tuned (search mode) in large pitch steps outside the capture range of the demodulator circuit (47) in the event that the synchronising signals or signals obtained therefrom are not identified and is fine-tuned in small pitch steps within the capture range in the event that the synchronising signals or signals obtained therefrom are identified.

2. Receiver in accordance with Claim 1, wherein the large pitched step is smaller than the capture range of the demodulator (47), in particular, 250 kHz.

3. Receiver in accordance with Claim 1 or 2, wherein the small pitched step is dimensioned, in particular, 62.5 kHz, such that no interference is caused to the output signal during the tuning process within the capture range.

4. Receiver in accordance with Claim 1 or 2, wherein the AFC circuit (1) comprises a comparator circuit (48) which compares the signal from the automatic frequency control process (AFC signal) with an upper and a lower threshold value and provides the control circuit with the direction of tuning.

5. Receiver in accordance with Claim 4, wherein the comparator circuit (48) comprises a first comparator (20) for the upper and a second comparator (21) for the lower threshold value and the AFC tuning voltage (32) is supplied to the one inputs (16, 17) of the comparators (20, 21) and comparison voltages are supplied to the other inputs (18, 19) via a voltage divider circuit (5 - 9).

6. Receiver in accordance with Claim 5, wherein the two end terminals of the voltage divider circuit (5 - 9) are at fixed reference voltages (+U, earth) and a tapping point is connected to an adjustable reference voltage (Uₑᵢₙₛₜ).

7. Receiver in accordance with Claim 6, wherein a further tapping point is connected to a regenerative feedback voltage (Uₘᵢₜ) which is taken from the outputs (22, 23) of the comparators (20, 21).

8. Receiver in accordance with Claim 6 or 7, wherein the adjustable reference voltage (Uₑᵢₙₛₜ) is set at a value which tunes the carrier oscillator (36) to a nominal frequency (fₙₑₙₙ).

9. Receiver in accordance with any of the Claims 1 to 8, wherein the input signal of the control circuit (34), which is derived from the synchronising signal processing circuit (40), is affected by a circuit for evaluating the error frequency (concealment) in the received signals and in which an integration of the error signals takes place, and the integrated error signals serve as a criterion for changing the pitch of the steps.

10. Receiver in accordance with any of the Claims 1 to 9, wherein tuning using small pitched steps occurs in both directions of tuning.

11. Receiver in accordance with any of the Claims 1 to 10, wherein tuning is not effected within a window around the centre frequency of the demodulator (47) which has a width of less than two small pitched steps.

12. Receiver in accordance with any of the Claims 1 to 11, wherein there is provided a mixing program for controlling the change-over from the search mode to the AFC regulating process.

13. Receiver in accordance with any of the Claims 1 to 12 for the reception and processing of digitally coded audio or video signals.

## Revendications

1. Un récepteur de radiodiffusion par satellite dont au moins un convertisseur de fréquence (42, 43) reçoit des signaux appropriés via une partie réception (33) comportant un oscillateur à battements (44), un circuit démodulateur (47) avec un oscillateur porteur (36) et un circuit d'évaluation du signal synchrone (40) pour la récupération du signal, caractérisé en ce que l'oscillateur à battements (44) est un oscillateur de battements à boucle à verrouillage de phase avec possibilité d'accord par intervalles courts ou espacés et en ce que des signaux d'entrée d'un circuit de commande (34) sont dérivés du circuit d'évaluation du signal synchrone (40) et du circuit démodulateur (47). Au moyen de ce circuit de commande, l'oscillateur de battements à boucle à verrouillage de phase (44) en dehors de la plage de réception du circuit démodulateur (47) sera accordé (mode recherche) par intervalles espacés en cas de non-détection des signaux synchrones ou des signaux ainsi captés et dans la plage de réception du circuit démodulateur (47) sera accordé plus précisément par petits intervalles en cas de détection des signaux synchrones ou des signaux ainsi captés.

2. Un récepteur selon la revendication 1 pour lequel l'intervalle important est inférieur à la plage de réception du démodulateur (47), en particulier 250 kHz.

3. Un récepteur selon la revendication 1 ou 2 pour lequel le petit intervalle est défini de telle façon (en particulier 62,5 kHz) que lors de la procédure d'accord dans la plage de réception aucun influence négative n'affectera le signal de sortie.

4. Un récepteur selon la revendication 1 ou 2 pour lequel le circuit CAF (1) comporte un circuit comparateur (48) qui compare le signal de contrôle automatique (signal CAF) à une valeur seuil plancher et à une valeur seuil plafond et indique le sens d'accord du circuit de commande (34).

5. Un récepteur selon la revendication 4 pour lequel le circuit comparateur (48) comporte un premier comparateur (20) pour la valeur seuil plafond et un second comparateur (21) pour la valeur seuil plancher et pour lequel la tension d'accord CAF est acheminée vers les entrées (16, 17) des comparateurs et les tensions de comparaison sont acheminées vers les autres entrées (18, 19) via un circuit diviseur de tension (5 - 9).

6. Un récepteur selon la revendication 5 dont deux prises terminales du circuit diviseur de tension (5 - 9) sont à des tensions de référence fixes (+U, masse) et un branchement est à une tension de référence réglable U_{réglable}.

7. Un récepteur selon la revendication 6 sur lequel une prise supplémentaire est à une tension de réaction positive (U_{réac. +}) et est branchée sur les sorties (22, 23) des comparateurs (20, 21).

8. Un récepteur selon la revendication 6 ou 7 dont la tension de référence réglable (U_{réglable}) est réglée sur une valeur qui accorde l'oscillateur porteur (36) sur une fréquence nominale (fₘₒₘᵢₙₐₗₑ)·

9. Un récepteur selon l'une des revendications 1 à 8 pour lequel le signal d'entrée du circuit de commande (34) dérivé du circuit d'évaluation du signal synchrone (40) est influencé par un circuit de commande pour l'évaluation du taux d'erreur (« Concealment ») des signaux reçus et dans lesquels se produit une intégration des signaux d'erreur. Les signaux d'erreur intégrés servent de critère pour la commutation de la longueur d'intervalle.

10. Un récepteur selon l'une des revendications 1 à 9 pour lequel l'accord se fait par petits pas dans les deux sens.

11. Un récepteur selon l'une des revendications 1 à 10 pour lequel aucun accord ne se fait dans une fenêtre autour de la fréquence intermédiaire du démodulateur (47) d'une largeur inférieure à deux petits pas.

12. Un récepteur selon l'une des revendications 1 à 11 pour lequel un programme mixte pour la commande de la commutation du mode recherche en mode réglage CAF est prévu.

13. Un récepteur selon l'une des revendications 1 à 12 pour la réception et le traitement des signaux audio et vidéo numériques codés.
